Europäisches Patentamt

European Patent Office

Office européen des brevets

(19)

(11) Publication number: 0 266 522 B1

(12) **EUROPEAN PATENT SPECIFICATION**

(45) Date of publication of patent specification: 15.07.92    (51) Int. Cl.5: **H01L 21/31**, H01L 21/312

(21) Application number: **87113463.1**

(22) Date of filing: **15.09.87**

The file contains technical information submitted after the application was filed and not included in this specification

(54) **Polyimide stud transfer process.**

(30) Priority: **06.11.86 US 927623**

(43) Date of publication of application:
**11.05.88 Bulletin 88/19**

(45) Publication of the grant of the patent:
**15.07.92 Bulletin 92/29**

(84) Designated Contracting States:
**CH DE ES FR GB IT LI NL SE**

(56) References cited:
**EP-A- 0 004 219**
**EP-A- 0 165 513**
**EP-A- 0 182 998**
**EP-A- 0 199 300**
**US-A- 4 353 159**

**IBM TECHNICAL DISCLOSURE BULLETIN, vol. 22, no. 8B, January 1980, pages 3652-3655, New York, US; P. BAKOS et al.: "Via communication between layers of printed circuitry utilizing polyimide as a dielectric"**

(73) Proprietor: **International Business Machines Corporation**
**Old Orchard Road**
**Armonk, N.Y. 10504(US)**

(72) Inventor: **Chaloux, Paul Normand, Jr.**
**68 Balfour Drive**
**Wappingers Falls NY 12590(US)**
Inventor: **Houghton, Thomas Frederick**
**24 Birch Drive**
**Beacon NY 12508(US)**

(74) Representative: **Klein, Daniel Jacques Henri Compagnie IBM France Département de Propriété Intellectuelle**
**F-06610 La Gaude(FR)**

EP 0 266 522 B1

## Description

Background of the Invention

The present invention relates generally to the manufacture of high performance VLSI semiconductor chips, and more particularly to a method for forming via openings in a first layer that has no etch selectivity relative to a second layer disposed therebelow. EP-A-0 004 219 and IBM Technical Disclosures Bulletin, Vol. 22 No. 8B, pages 3652 - 3655 (1980), both show prior art methods for forming via openings.

A standard semiconductor chip comprises an array of electronic devices which must be interconnected by patterns of conductive wires to perform a desired analog or digital function. These wire patterns are typically separated and insulated from the semiconductor chip by a layer of an insulating material such as $SiO_2$ or $Si_2N_3$. Contact is made between the electronic devices and the overlay of wires by means of conductive connections through the insulating material.

For small diameter semiconductor wafers of less than 12 centimeters, these conductive stud connections to the various semiconductor chips formed in the wafer can be made by means of metal evaporation through a liftoff stencil. In this technique, spaced pedestals with overhangs are formed on the semiconductor surface, as the liftoff stencil. When metal is evaporated at the proper angle into the spaces between the various pedestals, the pedestal overhangs insure that the area directly below the overhangs remain free of metal. The evaporated metal layer is then immersed in a solvent which attacks the pedestals through the metal-free areas between the bases of the pedestals and the evaporated metal to thereby effect the pedestal removal, while leaving the conductive studs.

However, this technique cannot be used to form studs on semiconductor wafers greater than 12 centimeters in diameter because there is no known method of evaporating metal with the required small angle of incidence to effect liftoff. The use of evaporation techniques on such large diameter substrates results in metal deposits under the pedestal overhangs (due to the wider angle of incidence), thereby preventing pedestal removal and causing short circuits.

A further problem with the evaporated metal technique is that it is difficult to properly deposit an insulating layer in high aspect ratio (height/width ratio) spaces between adjacent metal studs after the stencil has been removed. Voids tend to form between the studs. As the space between adjacent 2-3 micron high studs drops below 2 microns, this insulation problem becomes especially acute.

A yet further problem with metal liftoff techniques generally is that they are complex processes with intrinsically high defect density levels.

An alternative strategy commonly used in forming higher levels of metallization is based on the definition of via holes in the interlevel insulator layers by means of a substractive etch process, such as reactive ion etching, and the filling of the via holes with interconnection metal. However, it is difficult to effect this process in forming metal studs connecting to the semiconductor wafer because the standard $CF_4$ RIE cycle used to etch the via holes in the $SiO_2$ insulating layer also attacks the silicon devices therebelow during the overetch necessitated by the differing contact depths and sizes, and the lack of effective etch stops. In the great majority of cases, this silicon device attack is unacceptable and leads to device failures.

The invention as claimed is intended to remedy the above-described problems in forming via holes down to a semiconductor device.

The advantage offered by the present invention is that via holes may be formed through an insulating layer down to a substrate without attacking the substrate, despite the fact that the insulating layer has no etch selectivity relative to the substrate. Additionally, these via holes are formed with relatively low aspect ratios, despite the varying topography of the underlying semiconductor devices.

Summary of the Invention

The method of forming via openings according to the invention is disclosed in claims 1 to 5.

In an embodiment of the present invention, the method may include the step of filling the via openings by depositing a first barrier metal in the via openings to cover the bottom and at least a portion of the sidewalls of the vias, and then depositing a second metal into the via openings on top of the first barrier metal.

Brief Description of the Drawings

Figs. 1A-1G comprise schematic cross-sectioned diagrams of one embodiment for carrying out the various steps of the present method invention.

Detailed Description of an Embodiment

The present invention has broad applicability to any manufacturing situation wherein via openings must be formed in a first layer of an insulating material disposed on a surface of a substrate, wherein the insulating material has no etch selectivity relative to the substrate. The desired result of the present method is shown in Fig. 1F. Therein there is shown a first layer 12 of an insulating material disposed on a surface 11 of a substrate 10, wherein the insulating material has no etch selectivity relative to the substrate material. The purpose of the present method is to form via openings 14 in this first layer 12 down to the substrate 10, but without attacking the substrate 10.

The present invention will now be described in the context of one embodiment for the formation of via openings through an insulating layer 12 down to a semiconductor substrate 10.

The invention will now be disclosed in the context of Figs. 1A-1G. The first step is to form a plurality of free-standing studs 20 on the substrate surface 11 at selected locations, prior to the application of the insulating layer. These free-standing studs 20 are to be formed from a polymer material which is substantially attacked by an etch process, which process does not attack the insulating material or the substrate. The free-standing studs resulting from this method step are shown in Fig. 1C.

The next step comprises forming the first layer 12 of the insulating material on the substrate surface 11 and around the studs 20. This method step is shown in Fig. 1D.

The next step in the method comprises selectively removing only the studs 20 by means of the etch process to leave a plurality of via openings 14 in the insulating layer 12 at the selected stud locations. This method step is shown in Fig. 1F.

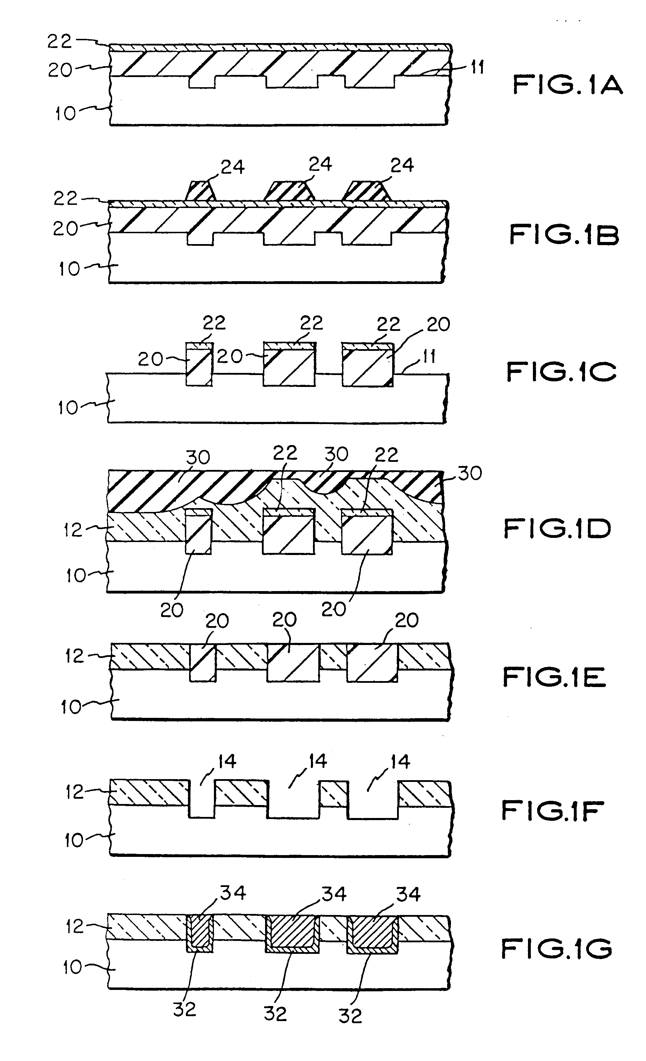

In the present invention, the insulating layer 12 forming step further includes the step of planarizing the insulating layer down to a desired level which is at least down to the tops of the free-standing studs 20, with the planarizing step being performed prior to the stud removing step. The results of this planarizing step are shown in Fig. 1E.

A very specific example of the present invention will now be disclosed wherein via openings 14 are formed in an insulating layer 12 of a silicon-based insulator such as $SiO_2$ disposed over a silicon substrate 10. It should be noted that there are a variety of different steps that may be involved, depending on the type of material involved, and the ground rules utilized in manufacturing the product. Referring now to Fig. 1A, a silicon substrate 10 is shown. Typically, this silicon substrate 10 is comprised of monocrystalline silicon. This silicon substrate 10 typically is an integrated circuit device having active and passive devices fabricated therein (not shown) and means for electrically isolating these devices from each other. The first step in the method of the present invention comprises forming a plurality of free-standing studs on the silicon substrate 10 at selected locations, prior to the application of the insulating layer. These studs are to be formed from a polymer material which is substantially attacked by an etch process which does not attack the insulating material or the substrate. This step may be accomplished, by way of example, by first precleaning the surface of the silicon substrate 10 with an isopropyl alcohol/N butyl acetate/$H_2O$ rinse-dry cycle. After this cycle is completed, the surface is treated by a 30 second dip in a solution of 0.1% aminotoluene silane in water, followed by a rinse and dry cycle. Such precleaning steps are well known in the art.

The next step comprises applying a layer 20 of a desired polymer material. Generally, the polymer material chosen should have a high temperature stability of over 400°C and a suitable viscosity such that it flows during the deposition and to a small extent during the curing cycle. The thickness of the polymer layer is controlled by the viscosity of the polymer deposited on the wafer and the rate at which it is spun during the deposition. In a preferred embodiment, this polymer material 20 should be a polyimide such as an isoimide. An example of such a material is commercially available and sold under the trademark THERMID 600-P, manufactured by the National Starch Company. There are a number of standard methods which may be utilized to form the polyimide layer 20. By way of example, the polyimide may be applied to a thickness of 1.8 microns, by depositing the material in liquid form on the silicon substrate 10 and then spinning at 4500 RPM for 45 seconds. This spinning action flows the material over the surface of the silicon substrate 10 to a relatively uniform thickness. The material is then heated to a temperature of 170°C for 10 minutes on a continually moving wafer track purged with $N_2$ (or five minutes on a hot plate). This heating of the polyimide material operates to reflow the material. The polyimide is then baked at 250°C for thirty minutes in an atmosphere of $N_2$ (or five minutes on a hot plate). This second heating of the polyimide material causes imidization. Finally, the polyimide material is baked a third time at 400°C for one hour in an atmosphere of $N_2$. This third heating step ensures removal of volatile components from the material.

A protective oxide layer 22 is then formed over the polymer layer 20 by subjecting the polymer layer 20 to a CVD oxide plasma at 250°C for a period sufficient to deposit a CVD-enhanced oxide layer to a depth of 200 nm (2000 angstroms). The process up to this point is shown in Fig. 1A.

In order to form the polymer studs 20, a layer of photoresist is then deposited on the oxide layer 22. This photoresist layer is exposed through an appropriate mask with the inverse of the desired stud pattern thereon. The photoresist layer is then developed and those portions which were exposed are removed by a solvent in accordance with known technology. The patterned photoresist layer 24 is shown in Fig.1B.

The next step is to etch down through the areas not covered by the photoresist mask layer 24. A variety of different etch processes may be utilized in order to accomplish this step. For the polyimide example of Fig. 1, a two-step reactive ion etch process is used. The first etch step is a short $CF_4$ etch for removing the oxide layer 22. The short first etch step is followed by an $O_2$ etch step. The $O_2$ attacks the polyimide, but does not attack silicon. Each etch step is accomplished in this process by generating a reactive ion plasma by subjecting the appropriate gas to energy from an RF power source. A typical apparatus for performing this operation is illustrated in U.S.-A-3,598,710. By way of example and not by way of limitation, the $CF_4$ ambient may be at 40 microns pressure with a flow rate of 30 SCCM, with an RF power of 400 Watts, for ten minutes. This $CF_4$ etch ambient is followed by the $O_2$ ambient, at a pressure of 2 microns, a flow rate of 100 SCCM, and an RF power of 600 Watts, for a time measured from the end point plus 25 percent etching. An advantage to the use of reactive ion etching is that the sidewalls of the resulting polymer studs 20 are substantially vertical. It should be noted for information that a typical method for determining the etch end point is by means of an optical fringe detector which counts the fringes as the depth of the trench increases. The free-standing studs resulting from the above described process steps are shown in Fig. 1C.

The next step is to form the insulating layer 12 on the substrate 10 and around the studs 20. This method step may be accomplished by sputtering an insulator layer 12 around and on top of the polyimide studs 20. By way of example, this insulator may be a silicon-based insulator such as $SiO_2$. Typical parameters that may be used to sputter the $SiO_2$ comprise an anode bias of 110 volts, a power of 2.3KW for ten minutes, followed by a second $SiO_2$ sputtering with an anode bias of 430 volts, a power of 4.4 KW, for a time equivalent to 9.5 fringe peaks (the optical fringes counted by an optical fringe detector). Typically, each peak is equivalent to 2000 angstroms in thickness so that the total thickness of the $SiO_2$ layer 12 is approximately 2300 nm (23 000 angstroms) + 250 nm (2500 angstroms).

Note that the $SiO_2$ sputtering as described above substantially inhibits attack by the accelerated $SiO_2$ particles on the polyimide studs 20 due to the low power and low bias sputtering parameters used.

At this point, it is necessary to planarize and remove this insulating layer 12 down to at least the tops of the polymer studs 20. In fact, this removal could be down through a substantial portion of the polymer studs 20 in order to significantly reduce the aspect ratio of the via holes. There are a number of methods available for performing this removing and planarizing step. In a preferred embodiment of the present invention, a photoresist layer is applied to the obtain planarization prior to removing the insulating layers down to the tops of the polymer studs 20. The first step in this preferred process is to subject the $SiO_2$ layer 12 to a 4% vapor HMDS at 48 C for ten minutes in order to promote adhesion of the photoresist. The next step is to apply the photoresist. A standard photoresist that may be utilized is "AZ 1350 J" (trademark of American Hoechst Corporation) or IBM TNS resist. This photoresist may be applied to a thickness of on the order of 1.9 microns and baked at 90°C for ten minutes on a wafer track which is continually moving and is being purged with $N_2$. The photoresist layer deposited in this manner tends to mound over the studs 20. In order to eliminate this photoresist mounding, a blockout mask is disposed over the photoresist layer to expose the photoresist directly above the studs 20. The photoresist layer is then developed, and rinsed in a solvent to remove the photoresist disposed directly above the polymer studs 20. The photoresist layer is then dried and baked at 230°C for 20 minutes in a standard $N_2$ oven to reflow the photoresist to provide a more even surface. A second photoresist layer of TNS is then applied to a thickness of 1.0 microns, and baked at 90°C for ten minutes. A second baking of the photoresist layer follows at 230°C for 20 minutes in a standard $N_2$ oven. The resulting structure with the photoresist 30 filling in the valleys in the $SiO_2$ layer 12 is shown in Fig. 1D.

The final step in this preferred method for removing and planarizing the device comprises a reactive ion etch step utilizing a mixture of 92% $CF_4$ and 8% $O_2$ at 100 microns pressure, a flow rate of 50 SCCM, a power of 1350 Watts, and utilizing an etching to the end point plus 300 nm (3000 angstroms). The end point is measured by determining when the plasma oxide layer 22 disposed on the tops of the polymer studs 20 is reached. The resulting planarized device is shown in Fig. 1E.

The final step in the process is to selectively remove only the polymer studs 20. This step may be conveniently accomplished by means of a standard $O_2$ ashing to remove 3000 nm (30,000 angstroms) (the etch point plus 50%). This point in the process is shown in Fig. 1F.

Prior to filling the via openings 14, the RIE residue from the previous $O_2$ ashing step must be removed. This may be accomplished by rinsing the exposed surfaces of the device to a solution of 40:1 BHF/GLYCERINE at 28°C for 20 seconds and then running the wafer through a dry cycle.

It is desired to fill the via openings 14 with an electrical conductor. If a metal is to be used which tends to penetrate into the silicon, then it is desirable to utilize a barrier type metal system such as Ti/W in the via openings 14 to cover the bottom and at least a portion of both of the sidewalls of the vias so that the first barrier metal essentially forms a cup. This barrier metal cup 32 is shown in Fig. 1G. A second metal 34 such as, for example, an alloy of Al/Cu may then be deposited into the via openings 14 on top of the first barrier metal cup 32. These metal deposition steps can be performed by standard sputtering techniques. By way of example, the first barrier metal layer may be formed by sputter depositing Ti/W to a depth of 2000 angstroms. This is followed by sputtering the second metal 34 of Al/Cu to a depth of 1350 nm (13500 angstroms) using a pressure of 5 microns of argon, a bias of -175 volts, a power of 8KW, with 23 amps utilized for the heater. This may be followed by a sputter deposition of 250 nm (250 angstroms) of Ti using a five micron argon pressure, a zero volt bias, a power of 3KW and no heating. This Ti sputtering may then be followed by a sputtered deposition of 1350 nm (13500 angstroms) of Al/Cu at a pressure of five microns of argon, a bias of -175 volts, a power of 8KW, and a heating amperage of 20 amps.

The present invention comprises a method for forming via openings through an insulating layer down to a substrate without attacking the substrate, even if the insulating layer has no etch selectivity relative to the substrate.

Additionally, these via openings may be formed with relatively low aspect ratios, despite the varying topography of the underlying second layer.

In a preferred embodiment of the present invention, a method is disclosed wherein the via openings may be defined in a silicon-based insulator (SiO2, $Si_2N_3$, etc.) with standard $CF_4$ reactive ion etches, but without attacking underlying inorganic silicon-based insulators or devices.

Note that the present method may also conveniently be used to form a via hole through an insulating layer down to a metal land. This technique is advantageous because the use of a polymer material to form the via opening prevents mouseholes from forming adjacent to the existing metal lands if the via holes are misaligned.

## Claims

1. A method for forming a via-opening in an insulating layer which is disposed on the surface of a substrate (10) comprising the steps of:
    a) forming a free-standing polymer stud (20) on said substrate surface ;

   b) forming an insulating layer (12) around and on top the polymer stud with a thickness which exceeds height of said polymer stud ;
   c) removing the insulating material in excess from the structure until the insulating layer and the stud top are substantially in a coplanar relationship (Fig. 1E); and,
   d) eliminating said polymer stud via an etch process which does not attack said insulating layer or said substrate, to leave a corresponding via opening (14) in the insulating layer (12) exposing thereby said substrate surface.

2. The method of claim 1 wherein step c comprises the steps of:
    c1) depositing a layer of a planarizing material onto the structure that has a substantially flat surface and etches with substantially the same rate that the material forming said insulating layer; and,
    c2) etching the structure until the top of said stud is exposed.

3. The method of claim 1 or 2 further including the step of:
    e) filling said via opening with metal (32, 34) to form a metal contact stud.

4. The method of any above claim wherein said polymer stud (20) consists of a polyimide stud with a thin plasma oxide cap (22).

5. The method of any above claim wherein the insulating layer forming material is a silicon based oxide (e.g. $SiO_2$).

## Revendications

1. Procédé pour former un trou traversant dans une couche isolante qui est située à la surface d'un substrat (10), qui comprend les étapes consistant à :
    a) former un plot de matériau polymère autonome (20) sur ladite surface du substrat ;
    b) former une couche isolante (12) autour et sur le sommet du plot de matériau polymère, à une épaisseur qui dépasse la hauteur dudit plot de matériau polymère ;
    c) enlever le matériau isolant en excès de la structure, jusqu'à ce que la couche isolante et le sommet du plot soient en relation substantiellement coplanaire; et
    d) éliminer ledit plot de matériau polymère, au moyen d'un procédé d'attaque qui n'attaque pas ladite couche isolante ou ledit substrat, de façon à laisser un trou traversant correspondant (14) dans la couche isolante (12), exposant ainsi ladite surface du substrat.

2. Procédé selon la revendication 1, dans lequel la phase c) comprend les étapes consistant à :

c1) déposer une couche de matériau planarisant sur la structure qui a une surface substantiellement plane et attaque substantiellement à la même vitesse que le matériau formant ladite couche isolante ; et

c2) attaquer la structure jusqu'à ce que le sommet dudit plot soit exposé.

3. Procédé selon la revendication 1 ou 2, comprenant en outre l'étape consistant à :

e) verser du métal (32, 34) dans le trou traversant pour former un plot métallique de contact.

4. Procédé selon l'une quelconque des revendications précédentes, dans lequel ledit plot de matériau polymère (20) est formé d'un plot de polyimide avec un capuchon en oxyde appliqué au plasma (22).

5. Procédé selon l'une quelconque des revendications précédentes, dans lequel le matériau formant la couche isolante est un oxyde à base de silicium (par exemple $SiO_2$).

**Patentansprüche**

1. Verfahren zum Formen einer Durchgangsöffnung in einer auf der Oberfläche eines Substrats (10) angeordneten Isolierschicht, welches die folgenden Schritte umfaßt:

a) auf der Substratoberfläche wird ein freistehender Polymerzapfen (20) gebildet;

b) um den Polymerzapfen herum und auf seinem oberen Ende wird eine Isolierschicht (12) ausgebildet, deren Dicke die Höhe des Polymerzapfens übersteigt;

c) das überschüssige Isoliermaterial wird von dem Aufbau entfernt, bis sich die Isolierschicht und das obere Zapfenende im wesentlichen in einer koplanaren Beziehung befinden (Fig. 1E); und

d) der Polymerzapfen wird mittels eines Ätzverfahrens, welches weder die Isolierschicht noch das Substrat angreift, entfernt, um eine entsprechende Durchgangsöffnung (14) in der Isolierschicht (12) zu hinterlassen und dadurch die Substratoberfläche freizulegen.

2. Verfahren nach Anspruch 1, bei welchem der Schritt C die folgenden Schritte beinhaltet:

C1) auf den Aufbau wird eine Schicht eines einebnenden Materials abgelegt, welche eine im wesentlichen ebene Oberfläche besitzt und welche im wesentlichen mit der gleichen Rate geätzt werden kann, wie das die Isolierschicht bildende Material; und

C2) der Aufbau wird geätzt, bis das obere Ende des Zapfens freigelegt ist.

3. Verfahren nach Anspruch 1 oder 2, welches ferner den folgenden Schritt beinhaltet:

e) die Durchgangsöffnung wird mit Metall (32, 34) gefüllt, um einen metallischen kontaktzapfen auszubilden.

4. Vorfahren nach einem der vorgehenden Ansprüche, bei welchem der Polymerzapfen (20) ein Polyimidzapfen mit einer dünnen Plasmaoxidkappe (22) ist.

5. Verfahren noch einem der vorgehenden Ansprüche, bei welchem das die Isolierschicht bildende Material ein Oxid auf Siliziumbasis (z.B. $SiO_2$) ist.

FIG.1A

FIG.1B

FIG.1C

FIG.1D

FIG.1E

FIG.1F

FIG.1G